(19)

Europäisches
Patentamt
European
Patent Office
Office européen
des brevets

(11) **EP 4 661 349 A1**

(12) **EUROPEAN PATENT APPLICATION**
published in accordance with Art. 153(4) EPC

(43) Date of publication:
**10.12.2025 Bulletin 2025/50**

(21) Application number: **24749974.2**

(22) Date of filing: **18.01.2024**

(51) International Patent Classification (IPC):
**H04L 25/49** *(2006.01)*     **H03M 7/20** *(2006.01)*
**H04J 13/10** *(2011.01)*

(52) Cooperative Patent Classification (CPC):
**H03M 7/20; H04J 13/10; H04L 25/49**

(86) International application number:
**PCT/JP2024/001267**

(87) International publication number:
**WO 2024/162020 (08.08.2024 Gazette 2024/32)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **31.01.2023 JP 2023013137**

(71) Applicants:
• **National Institute of Information and
Communications Technology
Koganei-shi,
Tokyo 184-8795 (JP)**
• **TOKYO UNIVERSITY OF SCIENCE FOUNDATION
Tokyo 162-8601 (JP)**

• **The University of Osaka
Osaka 565-0871 (JP)**

(72) Inventors:
• **PEPER, Ferdinand
Koganei-shi, Tokyo 184-8795 (JP)**
• **LEIBNITZ, Kenji
Koganei-shi, Tokyo 184-8795 (JP)**
• **HASEGAWA, Mikio
Tokyo 162-8601 (JP)**
• **WAKAMIYA, Naoki
Suita-shi, Osaka 565-0871 (JP)**

(74) Representative: **Grünecker Patent- und
Rechtsanwälte
PartG mbB
Leopoldstraße 4
80802 München (DE)**

(54) **COMMUNICATION PROGRAM AND METHOD FOR ALLOCATING PULSE CODE STRING**

(57)     A transmitter according to one aspect of the present invention generates a pulse code train by encoding transmission information according to assignment of each of one or more pulse code trains to a respective codeword, and transmits the generated pulse code train. Each of the one or more pulse code trains includes four or more pulses. Each of the one or more pulse code trains is designed so that any pair of the one or more pulse code trains has a maximum of two common pulses under all possible shifts of a discrete number of time slots. This makes it possible to provide a communication technique that can be expected to improve the data rate in data communication by a large number of devices.

Fig. 2

FIRST PULSE CODE TRAIN : 1 0 0 1 0 0 0 0 0 0 0 0 0 1 0 0 0 0 0 0 0 0 0 0 0 0 1 0 0 1

SECOND PULSE CODE TRAIN : 1 0 0 0 0 0 1 0 0 0 0 0 0 1 0 0 0 0 0 0 0 0 1 0 0 0 0 0 1

EP 4 661 349 A1

**Description**

Technical Field

The present invention relates to a communication program and a method of assigning a pulse code train.

Background Art

In recent years, there has been a growing need for the development of communication technology for a large number of devices to connect to the network and perform data communication. According to such communication technology, effective data communication can be realized, for example, in a case of monitoring the condition of each participant (e.g., body temperature) with a sensor at a large-scale gathering, a case of connecting a large number of nodes using LPWAN (low power wide area networks), a case of collecting information from a large number of tags (e.g., observing the ecology of aquatic organisms), etc. As one of the LPWA (LPWAN) communication standards, there is a LoRa WAN standard that enables communication over several kilometers even with a weak signal by using chirp spread spectrum for radio modulation.

Citation List

Non Patent document

Non Patent document 1: "What is LPWA (LPWAN)? Low Power Wide Area", [online], [searched on January 23, 2023], Internet <URL: https://soracom.jp/lpwa/>

Summary of the Invention

Problems to be solved by the invention

According to the communication method in the conventional LPWA communication standard, a relatively large number of (about $10^3$) devices can perform data communication. However, in the conventional method, the number of transmissions per unit time is small, and the data rate is low. Further, the number of devices capable of communication is still small for use in such cases as above. Therefore, it is desirable to realize a communication technique that enables more devices to perform data communication at a certain data rate.

The present invention has been made in view of such circumstances in one aspect, and an object thereof is to provide a communication technique that can be expected to improve the data rate in data communication by a large number of devices.

Means for solving the Problems

The present invention employs the following configurations in order to solve the above problems. Note that the following configurations of the invention can be combined as appropriate.

A communication program according to one aspect of the present invention is a program for causing a computer to execute: a step of generating a pulse code train by encoding transmission information according to assignment of each of one or more pulse code trains to a respective codeword; and a step of transmitting the generated pulse code train. Each of the one or more pulse code trains includes four or more pulses. Each of the one or more pulse code trains is designed so that any pair of the one or more pulse code trains has a maximum of two common pulses under all possible shifts of a discrete number of time slots.

In this configuration, even if devices perform data communication asynchronously, only a maximum of two pulses overlap (coincide), and therefore even if pulse codes transmitted from the devices coincide, each of the pulse codes can be decoded. Therefore, a large number of devices can perform communication simultaneously in the same frequency band, and the number of transmissions can be increased. Therefore, according to this configuration, it can be expected to improve the data rate in data communication by a large number of devices.

In the communication program according to the above one aspect, each of the one or more pulse code trains may include n pulses. n may be a natural number of four or more. For two pulse code trains that are paired, a minimum number of pulses dispositions of which do not coincide under all the possible shifts of time slots may be defined as a shifting distance. Designing each of the one or more pulse code trains may comprise designing each of the one or more pulse code trains so that a shifting distance between any pair of the one or more pulse code trains is 2n - 4. According to this configuration, it is possible to properly obtain pulse code trains having a maximum of two common pulses under all possible shifts. As a result, it can be appropriately expected to improve the data rate in data communication by a large number of devices.

In the communication program according to the above one aspect, for each of the one or more pulse code trains, two pulse intervals between three freely-selected pulses may be defined as a characteristic pair. Designing each of the one or more pulse code trains may comprise designing each of the one or more pulse code trains so that all characteristic pairs in the one or more pulse code trains are different (i.e., there are no overlapping characteristic pairs). According to this configuration, it is possible to properly obtain pulse code trains having a maximum of two common pulses under all possible shifts. As a result, it can be appropriately expected to improve the data rate in data communication by a large number of devices.

In the communication program according to the above one aspect, each of the one or more pulse code trains may further be designed so that a minimum pulse interval in the one or more pulse code trains is equal to or greater than a predetermined time interval width. For example, the transmission time in data communication may be stipulated by rules such as the Radio Law. According to this configuration, by setting a predetermined time interval width according to a rule, it is possible to comply with the rule and optimize the data rate in data communication.

In the communication program according to the above one aspect, each of the codewords assigned to the respective pulse code train may comprise one or more information bits and one or more check bits. According to this configuration, the robustness against communication errors can be increased by employing an error correction code.

In the communication program according to the above one aspect, the step of generating the pulse code train may comprise: a step of dividing the transmission information into a plurality of groups, wherein each of the groups comprises one or more information bits and one or more check bits and the number of bits belonging to each of the groups is the same; a step of generating a plurality of frames by repeating generation of one frame by extracting one bit from each of the groups until there is no more bit belonging to each of the groups; and a step of generating a plurality of the pulse code trains corresponding to the respective frames by handling each of the frames as a codeword. According to this configuration, the robustness against communication errors can be increased by employing an error correction code.

In the communication program according to the above one aspect, the plurality of frames may comprise one or more information frames to which the information bits belong and one or more check frames to which the check bits belong. In this configuration, the frames to which the check bits belong and the frames to which the information bits belong are distinguished. This makes it possible to prune the ambiguity of information when restoring information of each group.

The communication program according to each of the above aspects corresponds to information processing on the data transmission side. However, the form of the present invention may not be limited to such examples. In another example, one aspect of the present invention may correspond to information processing on the data reception side. In this case, in each of the above aspects, all or part of each of the above configurations may be employed in information processing on the data reception side, except for the point that the transmission processing is replaced with reception processing and encoding is replaced with decoding. In yet another example, one aspect of the present invention may be a method of assigning a pulse code train to a codeword (an information processing method).

For example, a communication program according to one aspect of the present invention may be a program for causing a computer to execute: a step of receiving a pulse code train; and a step of acquiring transmission information by decoding the received pulse code train according to assignment of each of one or more pulse code trains to a respective codeword. Each of the one or more pulse code trains includes four or more pulses, and each of the one or more pulse code trains is designed so that any pair of the one or more pulse code trains has a maximum of two common pulses under all possible shifts of a discrete number of time slots.

In the communication program according to the above one aspect, in the step of receiving, the computer may receive a plurality of the pulse code trains. Further, the received plurality of pulse code trains may be generated using: a step of dividing the transmission information into a plurality of groups, wherein each of the groups comprises one or more information bits and one or more check bits and the number of bits belonging to each of the groups is the same; a step of generating a plurality of frames by repeating generation of one frame by extracting one bit from each of the groups until there is no more bit belonging to each of the groups; and a step of generating a plurality of the pulse code trains corresponding to the respective frames by handling each of the frames as a codeword.

Further, a method of assigning a pulse code train to a codeword according to one aspect of the present invention is an information processing method, wherein a computer executes: a step of acquiring the number $N_c$ of codewords; a step of organizing candidates for $N_c$ pulse code trains assigned to respective codewords in blocks; and a step of verifying the organized candidates for $N_c$ pulse code trains. In the step of organizing, two fixed blocks and n-k free blocks are provided. Each of the provided blocks comprises a two-dimensional array. A first axis of each of the blocks corresponds to a codeword. The number of elements in a first axis direction of each of the blocks is set to coincide with the acquired number $N_c$ of codewords. A second axis of each of the blocks corresponds to the pulse code trains. Each element arranged in a second axis direction at each position in the first axis direction of each of the blocks as an element string in the second axis direction disposed at each position in the first axis direction of each of the blocks indicates presence or absence of a pulse in the candidates for pulse code trains assigned to the respective codewords by representing presence of a pulse using a first value and representing absence of a pulse using a second value. Each of the two fixed blocks is disposed at a respective one of a head and a tail in the second axis direction. The n-k free blocks are arranged in the second axis direction between the two fixed blocks. A series of element strings in the second axis direction extracted from each position in the first axis direction of the two fixed blocks and the n-k free blocks while being arranged in the second axis direction indicates each of the candidates for pulse code trains. In each of the two fixed blocks, the first value or a plurality of the first values are disposed in each element string in the second axis direction. In the two fixed blocks, a total number of the first values disposed in respective element strings in the second axis direction is k. n is equal to or greater than 4, and k is equal to or greater than 2 and less than n. In each element string in the second axis direction in the fixed block disposed at the head in the second axis direction, the first value is disposed at the head in the second axis direction. In each element string in the second axis direction in the fixed block disposed at the tail in the second axis direction, the first value is disposed at the tail in the second axis direction. The number of elements in the second axis direction of each of the free blocks is equal to or greater than the acquired number Nc of codewords. Organizing the candidates for Nc pulse code trains in blocks comprises disposing the first value in each element string in the second axis direction of each of the free blocks so that disposition of the first value does not overlap in the first axis direction and disposing the second value at each of the other positions. Further, in the step of verifying, each series of element strings in the second axis direction extracted from the two fixed blocks and the n-k free blocks is treated as each of the candidates for pulse code trains. For each of the candidates for pulse code trains, two pulse intervals between three freely selected pulses are defined as a characteristic pair. Verifying the candidates for Nc pulse code trains comprises determining whether or not there is a combination of coincident characteristic pairs in all characteristic pairs in the candidates for pulse code trains. When it is determined that there is a combination of coincident characteristic pairs in the step of verifying, the computer reorganizes the candidates for Nc pulse code trains by changing disposition of the first value in at least one of the n-k free blocks, and executes the step of verifying on the reorganized candidates for Nc pulse code trains. When it is determined that there is no combination of coincident characteristic pairs in the step of verifying, the computer adopts the organized candidates for Nc pulse code trains as pulse code trains assigned to the Nc codewords. According to this configuration, pulse code trains usable for the communication program according to each of the above aspects can be obtained appropriately. Note that in the above processing procedure, the tail fixed block may be omitted. In this case, a free block may be disposed at the tail, and k may be equal to or greater than 1 and less than n.

In the method of assigning a pulse code train according to the above one aspect, when candidates for Nc pulse code trains determined not to include a combination of coincident characteristic pairs are not obtained although a process of reorganizing the candidates for Nc pulse code trains is repeated a predetermined number of times or more, the computer may further execute a step of increasing the number of elements in the second axis direction by one or more in at least one of the n-k free blocks. After increasing the number of elements in the second axis direction by one or more in at least one of the n-k free blocks, the computer may reorganize the candidates for Nc pulse code trains by changing disposition of the first value, and execute the step of verifying on the reorganized candidates for Nc pulse code trains. According to this configuration, it is possible to control the time until the completion of the assignment of a pulse code train to each codeword (i.e., the generation of pulse code trains).

As another aspect of the communication program according to each of the above forms, one aspect of the present invention may be an information processing apparatus that implements all or part of each of the above configurations, an information processing system, an information processing method, or a storage medium storing a program and readable by a computer and other apparatuses, a machine and the like. Here, a storage medium readable by a computer and the like is a medium that stores information such as a program based on an electrical, magnetic, optical, mechanical, or chemical action.

Similarly, as another aspect of the method of assigning a pulse code train according to each of the above forms, one aspect of the present invention may be an information processing apparatus that implements all or part of each of the above configurations, an information processing system, a program, or a storage medium storing such a program and readable by a computer and other apparatuses, a machine and the like.

Effects of the invention

According to the present invention, it is possible to provide a communication technique that can be expected to improve the data rate in data communication by a large number of devices.

Brief Description of the Drawings

[Fig. 1] Fig. 1 schematically illustrates an example of a scene in which the present invention is applied.
[Fig. 2] Fig. 2 illustrates a specific example of pulse code trains designed so that only a maximum of two pulses coincide with each other under all shifts.

[Fig. 3] Fig. 3 illustrates a specific example of the result of calculating characteristic pairs from pulse code trains.

[Fig. 4] Fig. 4 illustrates a specific example of the minimum pulse interval.

[Fig. 5A] Fig. 5A illustrates an example of a process of generating pulse code trains.

[Fig. 5B] Fig. 5B illustrates a specific example of a process of generating pulse code trains.

[Fig. 5C] Fig. 5C illustrates a specific example of a process of generating pulse code trains.

[Fig. 6] Fig. 6 schematically illustrates an example of a hardware configuration of a transmitter according to an embodiment.

[Fig. 7] Fig. 7 schematically illustrates an example of a hardware configuration of a receiver according to the embodiment.

[Fig. 8] Fig. 8 schematically illustrates an example of a hardware configuration of an assignment apparatus according to the embodiment.

[Fig. 9] Fig. 9 schematically illustrates an example of a software configuration of the transmitter according to the embodiment.

[Fig. 10] Fig. 10 schematically illustrates an example of a software configuration of the receiver according to the embodiment.

[Fig. 11] Fig. 11 schematically illustrates an example of a software configuration of the assignment apparatus according to the embodiment.

[Fig. 12] Fig. 12 is a flowchart illustrating an example of a processing procedure performed by the transmitter according to the embodiment.

[Fig. 13] Fig. 13 is a flowchart illustrating an example of a processing procedure performed by the receiver according to the embodiment.

[Fig. 14] Fig. 14 is a flowchart illustrating an example of a processing procedure performed by the assignment apparatus according to the embodiment.

[Fig. 15] Fig. 15 schematically illustrates an example of a process of organizing candidates for Nc pulse code trains in blocks.

[Fig. 16A] Fig. 16A illustrates a specific example of disposition of each value in fixed blocks.

[Fig. 16B] Fig. 16B illustrates a specific example of the disposition of each value in fixed blocks.

Mode for Carrying Out the Invention

Hereinafter, an embodiment according to one aspect of the present invention (hereinafter also referred to as "the present embodiment") will be described based on the drawings. However, the present embodiment described below is only an illustration of the present invention in all respects. It goes without saying that various improvements and modifications can be made without departing from the scope of the present invention. That is, a specific configuration according to an embodiment may be adopted as appropriate in the implementation of the present invention. Note that although the data appearing in the present embodiment is described in natural language, more specifically, it is specified in pseudo-languages, commands, parameters, machine languages, or the like that can be recognized by computers.

§1 Application Example

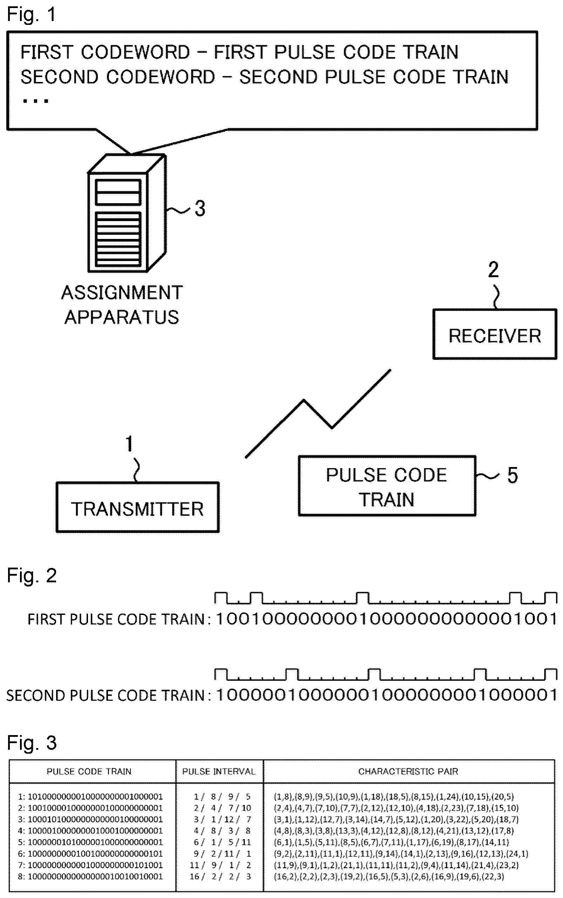

Fig. 1 schematically illustrates an example of a scene in which the present invention is applied. A system illustrated in Fig. 1 includes a transmitter 1, a receiver 2, and an assignment apparatus 3.

(Transmitter)

The transmitter 1 according to the present embodiment is one or more computers configured to transmit information using a pulse code train. The transmitter 1 is an example of a communication apparatus configured to perform a process of transmitting a pulse code train. In the present embodiment, the transmitter 1 generates a pulse code train 5 by encoding transmission information according to the assignment of each pulse code train to a respective codeword. Then, the transmitter 1 transmits the generated pulse code train 5.

(Receiver)

The receiver 2 according to the present embodiment is one or more computers configured to receive a signal of a pulse code train. The receiver 2 is an example of a communication apparatus configured to perform a process of receiving the pulse code train 5. In the present embodiment, the receiver 2 receives the pulse code train 5. Then, the receiver 2 acquires the transmission information by decoding the received pulse code train 5 according to the assignment of each pulse code train to a respective codeword. The transmission information is information to be transmitted. A codeword is information before being converted into a pulse code train.

(Design of Pulse Code Trains)

A codeword may be defined corresponding to each word (information word) constituting information (in one example of the present embodiment described later, a codeword may be defined according to a frame word). In the present embodiment, each pulse code train is assigned according to a respective codeword. That is, the disposition of each pulse included in a pulse code train is determined for each codeword. Different codewords are assigned different pulse code trains (in other words, the disposition of each pulse is different for each codeword) .

In the present embodiment, each pulse code train is configured to include four or more pulses. In addition, each pulse code train is designed so that any pair of pulse code trains has a maximum of two common pulses under all possible shifts of a discrete number of time slots. That is, each pulse code train is designed so that only a maximum of two pulses of the four or more pulses included in each pulse code train coincide (overlap) under all possible shifts.

The time interval width (length) of each pulse code train may be determined as appropriate. In one example, the time interval width of each pulse code train may be the same. In another example, the time interval widths of at least some of the pulse code trains may be different. The time interval width of each pulse code train is separated by time slots. The pulse interval may be defined by one or more time slot widths. For the convenience of description, unless otherwise specified, the pulse interval is treated as one time slot.

In one example, two pulses out of the four or more pulses constituting a pulse code train may be disposed in the head time slot (the first time slot) and the tail time slot (the last time slot). The remaining two or more pulses may be disposed between the head and tail pulses. A time slot part in which a pulse is disposed corresponds to a part with a pulse (on), and a time slot part in which no pulse is disposed corresponds to a part with no pulse (off).

Fig. 2 illustrates a specific example of pulse code trains designed to have a maximum of two common pulses (designed so that only a maximum of two pulses coincide with each other) under all possible shifts. In Fig. 2, "1" indicates that there is a pulse in the corresponding time slot. "1" is an example of the first value. "0" indicates that there is no pulse in the corresponding time slot. "9" is an example of the second value. The same notation is used in the following figures.

Each of a first pulse code train and a second pulse code train has a time interval width of 29 time slots and is configured to include five pulses. In the first pulse code train, a pulse is disposed in the 1st, 4th, 13th, 26th, and 29th time slots, and no pulse is disposed in the other time slots. In the second pulse code train, a pulse is disposed in the 1st, 7th, 14th, 23rd, and 29th time slots, and no pulse is disposed in the other time slots.

In this specific example, it is assumed that the first pulse code train is fixed and the second pulse code train is shifted in the positive-negative direction (the left-right direction in the figure). In this case, two pulses coincide between the first pulse code train and the second pulse code train under six conditions (a shift to the right by 12 time slots, a shift to the right by 6 time slots, a shift to the right by 3 time slots, no shift, a shift to the left by 3 time slots, and a shift to the left by 10 time slots). Under conditions other than these conditions, the number of coincident pulses is one or less.

Thus, each pulse code train assigned to a respective codeword is designed so that only a maximum of two pulses coincide under all possible shifts. More specifically, for example, in the case of a self-pair (a pair of the same pulse code trains) such as a pair of first pulse code trains and a pair of second pulse code trains in Fig. 2, all pulses coincide under the condition of no shift. On the other hand, for example, in the case of a pair of different pulse code trains, such as a pair of the first pulse code train and the second pulse code train in Fig. 2, not all pulses coincide even under the condition of no shift.

Therefore, each pulse code train may be designed so that for a self-pair (a pair of the same pulse code trains), only a maximum of two pulses coincide under all possible shift conditions except for the condition of no shift. In addition, each pulse code train may be designed so that for a pair of different pulse code trains, only a maximum of two pulses coincide under all possible shift conditions including the condition of no shift.

In the present embodiment, pulse code trains are generated with the above design being satisfied, and the generated pulse code trains are assigned to codewords. The assignment of a pulse code train to each codeword may be determined in advance before performing data communication between the transmitter 1 and the receiver 2. In one example, the assignment may be performed manually. In another example, the assignment may be performed automatically. In the present embodiment, the assignment can be automated through the processing performed by the assignment apparatus 3 described later.

The transmitter 1 may generate one or more pulse code trains 5 by encoding one or more codewords constituting the transmission information according to a predetermined assignment. Then, the transmitter 1 may transmit the generated one or more pulse code trains 5. In response, the receiver 2 may receive the one or more pulse code trains 5. The receiver 2 may acquire the transmission information by decoding each of the received one or more pulse code trains 5 according to the predetermined assignment.

(Assignment Apparatus)

The assignment apparatus 3 according to the present embodiment is one or more computers configured to generate pulse code trains that satisfy the above design and execute information processing for assigning the generated pulse code trains to codewords. In the present embodiment, the assignment apparatus 3 acquires the number Nc of codewords. The assignment apparatus 3 organizes candidates for Nc pulse code trains assigned to their respective codewords in blocks. Then, the assignment apparatus 3 verifies the organized candidates for Nc pulse code trains.

When the verification is not cleared, the assignment apparatus 3 repeatedly executes the organization process and the verification process. In the organization process, the assignment apparatus 3 changes the disposition of the pulses to reorganize the candidates for Nc pulse code trains. In the verification process, the assignment apparatus 3 verifies the reorganized candidates for Nc pulse code trains. On the other hand, when the verification is cleared, the assignment apparatus 3 adopts the organized candidates for Nc pulse code trains as pulse code trains assigned to the Nc codewords. The assignment result may be reflected in the transmitter 1 and the receiver 2 as appropriate. Details will be described later.

(Features)

As described above, in the present embodiment, data communication between the transmitter 1 and the receiver 2 is performed using a pulse code train. Each pulse code train is configured to satisfy the above design. As a result, even if a plurality of devices perform data communication asynchronously, for example, even if a plurality of transmitters 1 transmit data asynchronously to one receiver 2, only a maximum of two pulses coincide among the four or more pulses included in each pulse code train. That is, the remaining two or more pulses do not coincide. Therefore, even if the pulse code trains transmitted from respective transmitters 1 coincide, each of the pulse code trains can be decoded. As a result, a large number of devices can perform communication simultaneously in the same frequency band, and the number of transmissions can be increased. Therefore, according to the present embodiment, it can be expected to improve the data rate in data communication by a large number of devices. Further, according to the assignment apparatus 3, pulse code trains usable for such data communication can be obtained appropriately.

(Design Indices)

Each pulse code train may be obtained as appropriate so as to satisfy the above design. In the present embodiment, each pulse code train may be generated so as to satisfy the above design using at least one of the following two indices (a shifting distance and a characteristic pair).

(1) Shifting Distance

In the present embodiment, each pulse code train assigned to a respective codeword may include n pulses. n may be a natural number of four or more. For two pulse code trains that are paired, the minimum number of pulses dispositions of which do not coincide under all possible shifts of time slots may be defined as a shifting distance. Correspondingly, designing each of the pulse code trains may include designing each of the pulse code trains so that the shifting distance between any pair of the pulse code trains is 2n - 4.

Specifically, let v and w be two different pulse code trains defined by sets of spike times with any reference time. It is assumed that v is expressed as $\{T_k \mid k = 1, ..., n\}$ and w is expressed as $\{T_l \mid l = 1, ..., n\}$. In this case, the shifting distance $d_s$ (v, w) between the two different pulse code trains is defined by Equation 1 below. Still, the shifting distance $d_s$ (v) for the same pulse code train is defined by Equation 2 below.

[Equation 1]

$$d_s(v,w) = 2n - 2 \times \max_{\substack{i = 1, ..., n \\ j = 1, ..., n}} \left| \{T_k - T_i + T_j \mid k = 1, ..., n\} \cap \{T_l \mid l = 1, ..., n\} \right|$$

[Equation 2]

$$d_s(v) = 2n - 2 \times \max_{\substack{i = 1, \ldots, n \\ j = 1, \ldots, n \\ i \neq j}} \left| \{T_k - T_i + T_j \mid k = 1, \ldots, n \} \cap \{T_k \mid k = 1, \ldots, n \} \right|$$

The shifting distance of a code in the above definition is the minimum value of the shifting distances calculated using Equations 1 and 2 for all pulse code trains assigned to the codewords. It is clear that if the shifting distance is 2n - 4, the above design can be satisfied. In the present embodiment, the above design of pulse code trains may be achieved using this shifting distance. According to this index (shifting distance), it is possible to properly obtain pulse code trains having a maximum of two common pulses under all possible shifts. As a result, it can be appropriately expected to improve the data rate in data communication by a large number of devices.

(2) Characteristic Pair

In the present embodiment, for each pulse code train assigned to a respective codeword, two pulse intervals between three freely-selected pulses (i.e., the interval between the first pulse and the second pulse and the interval between the second pulse and the third pulse) may be defined as a characteristic pair. Correspondingly, designing each of the pulse code trains may include designing each of the pulse code trains so that all characteristic pairs obtained from the pulse code trains are different (i.e., coincident characteristic pairs are not generated).

At first, it is assumed that Nc pulse code trains ($P_1$, $P_2$, ..., $P_{Nc}$) are given. In any pulse code train, m + 1 pulses are selected. Their pulse times are assumed to be $pt_1$, $pt_2$, ..., $pt_{m+1}$. In this case, their pulse intervals (the interval between the first pulse and the second pulse, ..., the interval between the m-th pulse and the (m+1)-th pulse) are assumed to be $I_1$, $I_2$, ..., $I_m$. Any pulse interval $I_j$ is given by "$I_j = pt_{j+1} - pt_j - w_p$". $w_p$ is the time interval width (the number of time slots) of a pulse. For convenience of description, $w_p$ is assumed to be 1. In this case, a general-purpose characteristic m-tuple is defined by a set of m pulse intervals ($I_1$, $I_2$, ..., $I_m$) obtained from the selected m + 1 pulses. ($I_1$, $I_2$) in the case of m = 2 is defined as a characteristic pair. When the number of pulses included in a pulse code train is n, the number of characteristic pairs obtained from the pulse code train is $_nC_3$.

Fig. 3 illustrates a specific example of the result of calculating characteristic pairs from each of eight pulse code trains. In the specific example of Fig. 3, since each pulse code train includes five pulses, ten characteristic pairs are obtained from each pulse code train. It is assumed for example that two or more characteristic pairs obtained from the same pulse code train or two or more different pulse code trains should not coincide, so there should not be two or more characteristic pairs (1, 8). That is, it is assumed that there are no non-unique characteristic pairs in all characteristic pairs obtained from the pulse code trains assigned to the codewords. If this would not be the case, three pulses would coincide in the part where there would be non-unique characteristic pairs. Therefore, by making all characteristic pairs obtained from the pulse code trains different (i.e., all characteristic pairs are unique), the above design of pulse code trains can be achieved. In the specific example of Fig. 3, all characteristic pairs obtained from the pulse code trains are unique. Therefore, the eight pulse code trains illustrated in Fig. 3 satisfy the above design. According to this index (characteristic pair), it is possible to properly obtain pulse code trains having a maximum of two common pulses under all possible shifts. As a result, it can be appropriately expected to improve the data rate in data communication by a large number of devices.

(Minimum Pulse Interval)

In the present embodiment, each pulse code train assigned to a respective codeword may be further designed so that the minimum pulse interval (MPI) in the pulse code trains is equal to or greater than a predetermined time interval width.

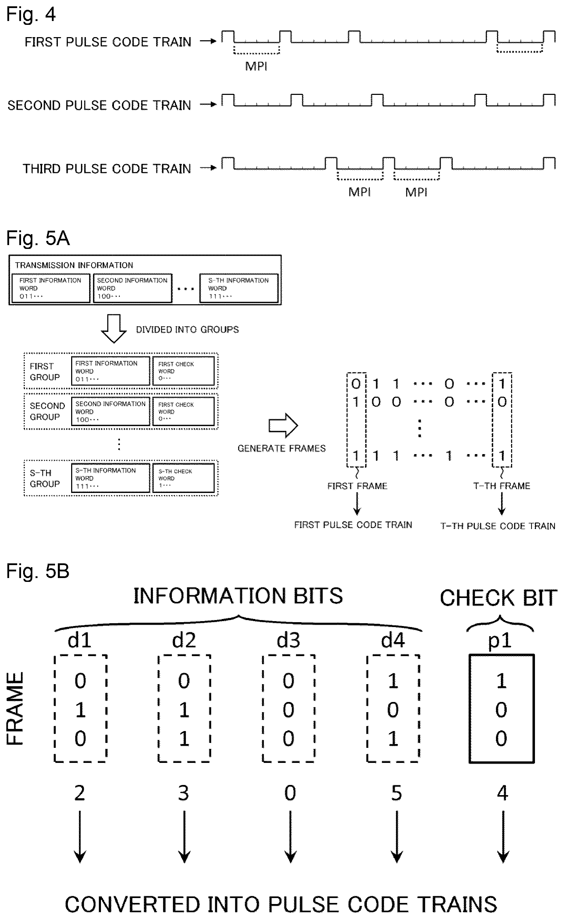

Fig. 4 illustrates a specific example of the minimum pulse interval. In the example of Fig. 4, three pulse code trains are given. The minimum pulse interval is generated in the first pulse code train (between the first pulse and the second pulse) and the third pulse code train (between the second pulse and the third pulse and between the third pulse and the fourth pulse). In this example, the minimum pulse interval is four time slots.

The predetermined time interval width may be determined as appropriate. In one example, the predetermined time interval width may be set, for example, according to a rule such as in the Radio Law. As a specific example, it is assumed to be given a rule that the rest period in pulse transmission (the time interval width between two subsequent pulses transmitted by the same transmitter) is 50 milliseconds or more (i.e., the threshold is 50 milliseconds). In this case, each pulse code train may be designed so that the time interval width of the minimum pulse interval is 50 milliseconds or more. In the example in Fig. 4, if the time interval width of one time slot is 12.5 milliseconds or more, the design can be satisfied.

According to this design, it is possible to comply with the rule by setting the predetermined time interval width according to a certain rule. Further, the minimum pulse interval may be set to approach the threshold value given by the rule. In the above example, the minimum pulse interval is desirably as close to 50 milliseconds as possible. Thereby, the data rate in data communication can be optimized.

Note that the time interval width of the minimum pulse interval is determined by the number of time slots constituting the minimum pulse interval and the time interval width of a time slot. The order of determining the number of time slots constituting the minimum pulse interval and the time interval width of a time slot may be any order. In one example, after the time interval width of a time slot is determined, the number of time slots constituting the minimum pulse interval may be determined so that the minimum pulse interval is equal to or greater than the predetermined time interval width. In another example, after the number of time slots constituting the minimum pulse interval is determined, the time interval width of a time slot may be determined so that the minimum pulse interval is equal to or greater than the predetermined time interval width.

(Error Correction Code (Error Control Code))

In the present embodiment, an error correction code (an error control code) may be employed. As an example, a codeword may be obtained by adding a check word to an information word. That is, each codeword to which a respective pulse code train is assigned may be composed of one or more information bits and one or more check bits. For example, the check bits may be parity bits, redundant bits associated with the Hadamard code, or the like. The configuration of the check bits may be determined according to the scheme of the error correction code. This can increase the robustness against communication errors.

The process of obtaining codewords from the transmission information may not be particularly limited and may be determined as appropriate according to an embodiment. In an example of the present embodiment, the step of generating a pulse code train 5 in the transmitter 1 may be composed of the following three steps. That is, the transmitter 1 may divide the transmission information into a plurality of groups. Each group is composed of one or more information bits and one or more check bits. In addition, the number of bits belonging to each group is the same. Next, the transmitter 1 may generate a plurality of frames by repeating generation of one frame by extracting one bit from each group until there is no more bit belonging to each group. Then, the transmitter 1 may generate a plurality of pulse code trains corresponding to their respective frames by handling each frame as a codeword.

Fig. 5A illustrates an example of a process of generating pulse code trains. In the example of Fig. 5A, it is assumed that the transmission information can be divided into s information words. Each information word is composed of one or more information bits. In one example, each information word may correspond directly to the content of the information (e.g., a unit of information such as a number, a letter, or a symbol). In another example, each information word may not correspond to the content of the information. That is, it may be divided into s information words only for the purpose of obtaining groups.

First, the transmitter 1 divides the transmission information into s information words, and distributes each of the obtained information words to a respective one of the s groups. The length of each information word (the number of information bits) is set to be the same among the groups. Subsequently, the transmitter 1 adds a check word to each group. The configuration of the check word is determined depending on the scheme of the error correction code. The check word is composed of one or more check bits. The length of each check word (the number of check bits) is also set to be the same among the groups. Thereby, each group is composed of one or more information bits and one or more check bits. Further, the number of bits belonging to each group is set to be the same.

The disposition of the check word relative to the information word may be determined freely. In one example, as illustrated in Fig. 5A, the check word may be disposed behind the information word. The disposition of the check word may be the same or different among the groups. In another example, the check words may be disposed in their respective groups inconsistently.

Next, the transmitter 1 generates one frame by extracting one bit from each group. The transmitter 1 repeats the generation of a frame until there are no more bits belonging to each group. Thereby, the transmitter 1 generates a plurality of frames. Since the example of Fig. 5A assumes that each group includes t bits, t frames are generated. The values of s and t may be determined freely.

The bit extracted from each group may be selected freely. In one example, at least one of the plurality of frames may be configured to include both information bits and check bits. In another example, all frames may be configured to include only information bits or check bits. For example, bits may be extracted from each group, with information bits and check bits separated from each other. Thereby, the plurality of generated frames may be composed of one or more information frames to which information bits belong and one or more check frames to which check bits belong.

In the example of Fig. 5A, a check word is disposed behind an information word, and each group is indicated by row data. In this case, column data may be acquired as a frame. This makes it possible to extract bits from each group, with information bits and check bits separated from each other. However, the method of extracting bits may not be limited to the example of Fig. 5A.

Then, the transmitter 1 generates a plurality of pulse code trains corresponding to their respective frames by handling each frame as a codeword. Since t frames are generated in the example of Fig. 5A, t pulse code trains are generated.

By making the number of bits included in each group fewer than the number of bits included in each frame (i.e., t > s), the number of codewords to be assigned pulse code trains can be reduced. Thereby, since the number of pulse code trains can be reduced, the length of pulse code trains can be reduced. As a result, the computational cost required for generating pulse code trains can be reduced. Further, by generating each frame with information frames and check frames separated from each other, it is possible to prune the information frames according to the configuration of the check frames. That is, it becomes possible to prune the ambiguity of information when restoring the information of each group.

Fig. 5B illustrates a specific example of a process of generating pulse code trains. In the example of Fig. 5B, the transmission information is divided into three groups. Each information word is composed of four information bits (d1-d4). A parity bit is used as an error correction code (a check bit). A check word of each group is composed of one parity bit (p1). The parity bit of each group is determined so that the relation of "d1^d2^d3^d4^p1=0" is established ("^" indicates XOR). In this case, the transmitter 1 converts the transmission information into five pulse code trains. Then, the transmitter 1 transmits a pulse signal indicating each converted pulse code train. For each group including the parity bit, the receiver 2 can check whether the interpretation of the pulses is established or not / whether a transmission error has occurred or not depending on whether the above relation is established or not.

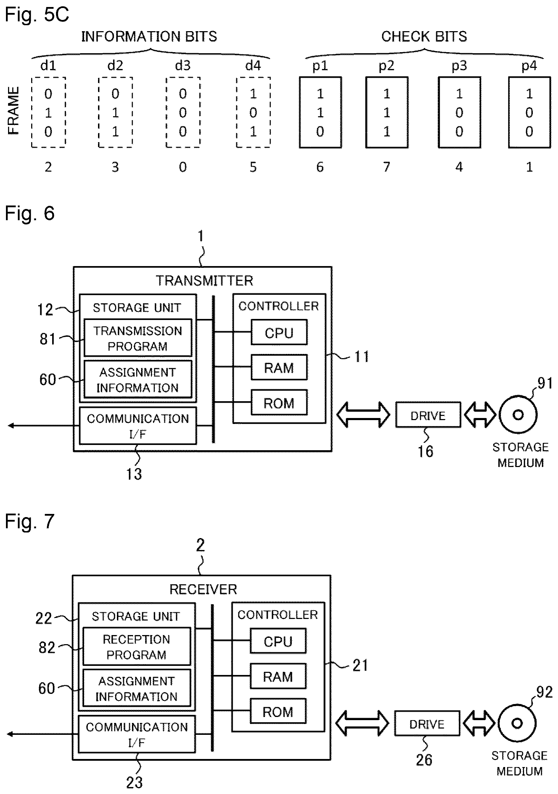

Fig. 5C illustrates another specific example of a process of generating pulse code trains. The example of Fig. 5C is obtained by extending the example of Fig. 5B so that the check word is composed of four parity bits (p1-p4). In the example of Fig. 5C, each parity bit is determined so that the relations of "d2^d3^d4^p1=0", "d1^d3^d4^p2=0", "d1^d2^d4^p3=0" and "d1^d2^d3^d4^p4=0" ("^" indicates XOR) are established. According to this example, when a transmission error or ambiguity of pulse interpretation occurs, the receiver 2 can identify the position of an error in an information bit depending on whether each relation is established or not, and restore the correct information bit.

As described above, in one example of the present embodiment, the step of generating the pulse code train 5 in the transmitter 1 may be composed of the above three steps. In one example of the present embodiment, the receiver 2 may receive a plurality of pulse code trains generated in these steps. In this case, the receiver 2 can obtain the transmission information using the reverse procedure of the processing procedure illustrated in Fig. 5A.

In other words, the receiver 2 may restore the information of each frame by decoding each obtained pulse code train. Subsequently, the receiver 2 may reproduce the information of each group from the information of each frame. At this time, the receiver 2 can check for transmission errors and prune the ambiguity according to the check word. In particular, the receiver 2 can remove all combinations of frames in which the above relation regarding the check bits is not established. In this case, without requiring finding the position of the error or retransmission, the receiver 2 can remove the ambiguity in decoding by simply checking the check bits. As illustrated in Fig. 5C, when the check word is configured to be able to restore the correct information bits, the receiver 2 can restore the correct information word according to the check word. On the other hand, when the check word is not configured to be able to restore the correct information bits, the receiver 2 may discard the received pulse code train. In this case, the receiver 2 may prompt the transmitter 1 to retransmit the pulse code train. Then, the receiver 2 can restore the transmission information by concatenating the information of each group.

Note that the process of obtaining codewords from the transmission information may not be limited to such examples. In another example, the transmitter 1 may treat each group as a codeword (i.e., the generation of frames may be omitted). In yet another example, the transmitter 1 may determine a codeword without grouping. Further, the error correction code may be omitted. In this case, in the examples of Figs. 5A-5C, the check bits (parity bits) may be omitted.

(Apparatus Configuration)

In the example of Fig. 1, the transmitter 1, the receiver 2, and the assignment apparatus 3 are each separate computers. However, the system configuration according to the present embodiment may not be limited to such examples, and may be determined as appropriate according to an embodiment. In another example, at least one combination of the transmitter 1, the receiver 2, and the assignment apparatus 3 may be composed of one computer. For example, a communication apparatus may be configured to be able to transmit and receive pulse code trains by including the transmitter 1 and the receiver 2.

§2 Example Configuration

[Hardware Configuration]

&lt;Transmitter>

Fig. 6 schematically illustrates an example of a hardware configuration of the transmitter 1 according to the present embodiment. In an example of Fig. 3, the transmitter 1 according to the present embodiment is a computer in which a controller 11, a storage unit 12, and a communication interface 13 are electrically connected.

The controller 11 includes a CPU (central processing unit), which is a hardware processor, a RAM (random access memory), a ROM (read only memory) and the like, and is configured to execute information processing based on programs and various data. The controller 11 (CPU) is an example of a processor resource. Note that the type of the hardware processor may not be limited to this. In another example, the hardware processor may include an FPGA (field programmable gate array), another hardware device, or the like.

The storage unit 12 includes, for example, a hard disk drive, a solid-state drive, a RAM, a flash memory, or the like. The storage unit 12 is an example of a memory resource. In the present embodiment, the storage unit 12 stores various information such as a transmission program 81 and assignment information 60.

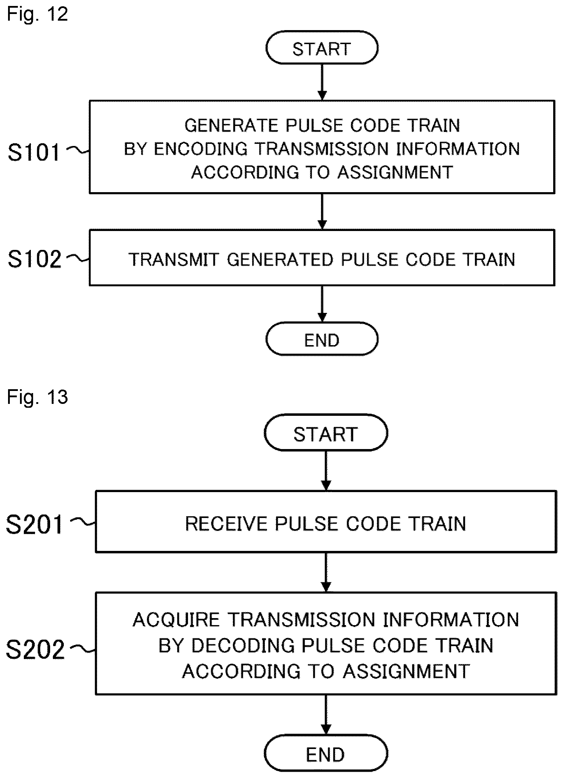

The transmission program 81 is a program for causing the transmitter 1 to execute information processing related to transmission of a pulse code train (in Fig. 12 described later). The transmission program 81 includes a series of instructions for the information processing. The transmission program 81 is an example of a communication program for causing execution of information processing on the transmission side. The assignment information 60 is configured to indicate the assignment of each pulse code train to a respective codeword (i.e., the correspondence between codewords and pulse code trains).

The communication interface 13 is an interface for performing wireless communication via a network. The communication interface 13 may be, for example, a wireless LAN (local area network) module, an optically-based communication module, an acoustically-based communication module, or the like. In the present embodiment, the transmitter 1 can transmit a signal of a pulse code train to another computer (e.g., the receiver 2) via the communication interface 13.

At least one of the transmission program 81 and the assignment information 60 may be stored on a storage medium 91. The transmitter 1 may acquire at least one of the transmission program 81 and the assignment information 60 from the storage medium 91. The storage medium 91 is a medium on which, in order to enable a computer or other apparatus, a machine, or the like to read various information such as a stored program, the information such as a program is stored based on an electrical, magnetic, optical, mechanical or chemical action. The transmitter 1 may acquire various information from the storage medium 91 via a drive 16. The transmitter 1 may be connected to the drive 16 in any manner. In one example, the transmitter 1 may further include an external interface (e.g., a USB port) and may be connected to the drive 16 via the external interface. The type of the drive 16 may be selected freely according to the type of the storage medium 91. Note that in the example of Fig. 6, a disc-type storage medium such as a CD or a DVD is illustrated as an example of the storage medium 91. However, the type of the storage medium 91 may not be limited to a disc type, and may be other than a disc type. Examples of the storage medium other than a disc type can include a semiconductor memory such as a flash memory.

Note that regarding the specific hardware configuration of the transmitter 1, components can be omitted, replaced, and added as appropriate according to an embodiment. For example, the controller 11 may include a plurality of hardware processors. The type of the hardware processors may not be particularly limited, and may be selected as appropriate according to an embodiment. The storage unit 12 may be composed of the RAM and the ROM included in the controller 11. The transmitter 1 may further include a sensor such as a temperature sensor, an infrared sensor, and a sound sensor, and may be configured to transmit sensor data with a signal of a pulse code train. The transmitter 1 may be a general-purpose PC (personal computer), a tablet PC, a mobile terminal, a sensor device, a tag device, or the like in addition to an information processing apparatus designed exclusively for the service provided.

<Receiver>

Fig. 7 schematically illustrates an example of a hardware configuration of the receiver 2 according to the present embodiment. In an example of Fig. 7, the receiver 2 according to the present embodiment is a computer in which a controller 21, a storage unit 22, and a communication interface 23 are electrically connected. The controller 21, the storage unit 22, and the communication interface 23 of the receiver 2 may be the same as the controller 11, the storage unit 12, and the communication interface 13 of the transmitter 1 described above.

In the present embodiment, the storage unit 22 stores various information such as a reception program 82 and the assignment information 60. The reception program 82 is a program for causing the receiver 2 to execute information processing related to reception of a pulse code train (in Fig. 13 described later). The reception program 82 includes a series of instructions for the information processing. The reception program 82 is an example of a communication program for causing execution of information processing on the reception side.

As in the example of the transmitter 1, at least one of the reception program 82 and the assignment information 60 may be stored on a storage medium 92. The receiver 2 may acquire at least one of the reception program 82 and the assignment information 60 from the storage medium 92. The receiver 2 may acquire various information from the storage medium 92 via a drive 26. The receiver 2 may be connected to the drive 26 in any manner. The drive 26 and the storage medium 92 may be the same as the drive 16 and the storage medium 91 described above.

Note that regarding the specific hardware configuration of the receiver 2, components can be omitted, replaced, and added as appropriate according to an embodiment. For example, the controller 21 may include a plurality of hardware processors. The type of the hardware processors may not be particularly limited, and may be selected as appropriate according to an embodiment. The storage unit 22 may be composed of the RAM and the ROM included in the controller 21. Further, the receiver 2 may be a general-purpose PC, a tablet PC, a mobile terminal, a wireless terminal, or the like in addition to an information processing apparatus designed exclusively for the service provided.

<Assignment Apparatus>

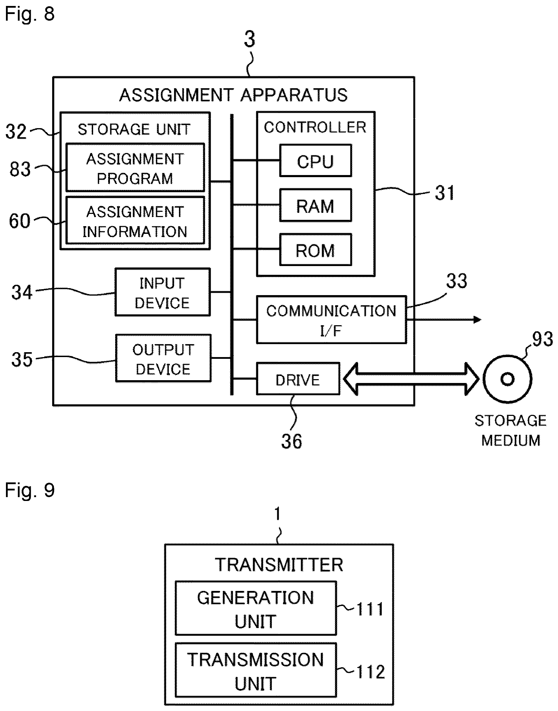

Fig. 8 schematically illustrates an example of a hardware configuration of the assignment apparatus 3 according to the present embodiment. In an example of Fig. 8, the assignment apparatus 3 according to the present embodiment is a computer in which a controller 31, a storage unit 32, a communication interface 33, an input device 34, an output device 35, and a drive 36 are electrically connected. The controller 31, the storage unit 32, and the communication interface 33 of the assignment apparatus 3 may be the same as the controller 11, the storage unit 12, and the communication interface 13 of the transmitter 1 described above.

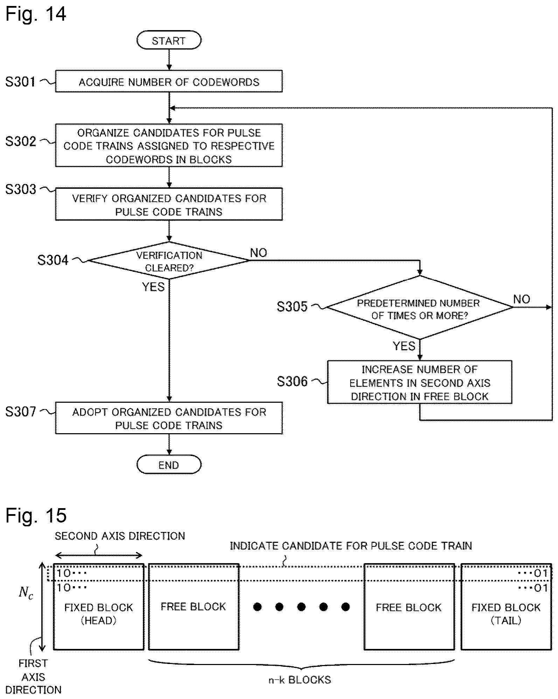

In the present embodiment, the storage unit 32 stores various information such as an assignment program 83 and the assignment information 60. The assignment program 83 is a program causing the assignment apparatus 3 to execute information processing (in Fig. 14 described later) for generating pulse code trains that satisfy the above design and assigning the generated pulse code trains to codewords. The assignment program 83 includes a series of instructions for the information processing. In the present embodiment, the assignment information 60 may be generated as a result of executing the assignment program 83.

As in the example of the transmitter 1, the assignment program 83 may be stored on a storage medium 93. The assignment apparatus 3 may acquire the assignment program 83 from the storage medium 93 via the drive 36. The storage medium 93 and the drive 36 may be the same as the drive 16 and the storage medium 91 described above. The assignment apparatus 3 may store the generated assignment information 60 on the storage medium 93.

The input device 34 is a device for receiving input of information from an operator. The input device 34 may be, for example, a mouse, a keyboard, and the like. The output device 35 is a device for outputting information to the operator. The output device 35 may be, for example, a display, a speaker, and the like. The operator can operate the assignment apparatus 3 by using the input device 34 and the output device 35. The input device 34 and the output device 35 may be formed integrally, for example, using a touch panel display or the like.

Note that regarding the specific hardware configuration of the assignment apparatus 3, components can be omitted, replaced, and added as appropriate according to an embodiment. For example, the controller 31 may include a plurality of hardware processors. The type of the hardware processors may not be particularly limited, and may be selected as appropriate according to an embodiment. The storage unit 32 may be composed of the RAM and the ROM included in the controller 31. At least one of the communication interface 33, the input device 34, the output device 35, and the drive 36 may be omitted. Further, the assignment apparatus 3 may be a general-purpose PC, a tablet PC, a mobile terminal, or the like in addition to an information processing apparatus designed exclusively for the service provided.

[Software Configuration]

<Transmitter>

Fig. 9 schematically illustrates an example of a software configuration of the transmitter 1 according to the present embodiment. The controller 11 of the transmitter 1 deploys the transmission program 81 stored in the storage unit 12 on the RAM. Then, the controller 11 executes instructions included in the transmission program 81 deployed on the RAM using the CPU. Thereby, the transmitter 1 according to the present embodiment is configured to include a generation unit 111 and a transmission unit 112 as software modules. That is, in the present embodiment, each software module of the transmitter 1 is implemented by the controller 11 (CPU).

The generation unit 111 is configured to generate a pulse code train 5 by encoding the transmission information according to the assignment of each pulse code train to a respective codeword. In the present embodiment, the generation unit 111 holds the assignment information 60. Thereby, the generation unit 111 can identify a predetermined assignment of pulse code trains to codewords (correspondence between codewords and pulse code trains) by referencing the assignment information 60. The transmission unit 112 is configured to transmit the generated pulse code train 5.

<Receiver>

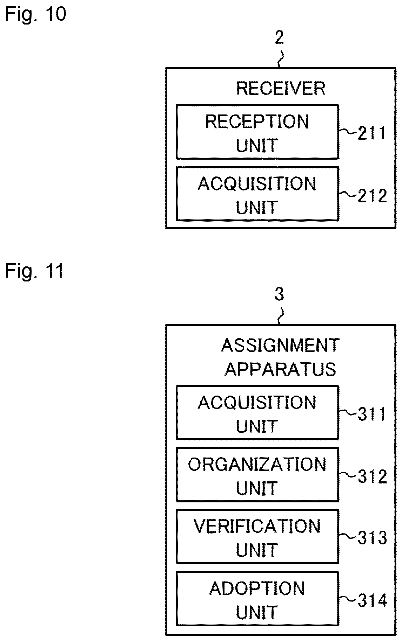

Fig. 10 schematically illustrates an example of a software configuration of the receiver 2 according to the present embodiment. The controller 21 of the receiver 2 deploys the reception program 82 stored in the storage unit 22 on the RAM. Then, the controller 21 executes instructions included in the reception program 82 deployed on the RAM using the CPU. Thereby, the receiver 2 according to the present embodiment is configured to include a reception unit 211 and an acquisition unit 212 as software modules. That is, in the present embodiment, each software module of the receiver 2 is also implemented by the controller 21 (CPU).

The reception unit 211 is configured to receive the pulse code train 5. The acquisition unit 212 is configured to acquire the transmission information by decoding the received pulse code train 5 according to the assignment of each pulse code train to a respective codeword. In the present embodiment, the acquisition unit 212 holds the assignment information 60. Thereby, the acquisition unit 212 can identify the predetermined assignment of pulse code trains to codewords by referencing the assignment information 60.

<Assignment Apparatus>

Fig. 11 schematically illustrates an example of a software configuration of the assignment apparatus 3 in Fig. 8 according to the present embodiment. The controller 31 of the assignment apparatus 3 deploys the assignment program 83 stored in the storage unit 32 on the RAM. Then, the controller 31 executes instructions included in the assignment program 83 deployed on the RAM using the CPU. Thereby, the assignment apparatus 3 according to the present embodiment is configured to include an acquisition unit 311, an organization unit 312, a verification unit 313, and an adoption unit 314 as software modules. That is, in the present embodiment, each software module of the assignment apparatus 3 is also implemented by the controller 31 (CPU).

The acquisition unit 311 is configured to acquire the number Nc of codewords. The organization unit 312 is configured to organize candidates for Nc pulse code trains assigned to their respective codewords in blocks. The verification unit 313 is configured to verify the organized candidates for Nc pulse code trains. When the verification is not cleared, the organization unit 312 is configured to change the disposition of the pulses to reorganize the candidates for Nc pulse code trains. Correspondingly, the verification unit 313 is configured to verify the reorganized candidates for Nc pulse code trains. These processes may be repeatedly executed until the verification is cleared. The adoption unit 314 is configured to adopt the organized candidates for Nc pulse code trains as pulse code trains assigned to the Nc codewords when the verification is cleared.

<Others>

The software modules of the transmitter 1, the receiver 2, and the assignment apparatus 3 will be described in detail in the operation example described later. Note that the present embodiment describes an example in which the software modules of the transmitter 1, the receiver 2, and the assignment apparatus 3 are all implemented by a general-purpose CPU. However, some or all of the software modules described above may be implemented by one or more dedicated processors. Each of the above modules may be implemented as a hardware module. Further, regarding the respective software configurations of the transmitter 1, the receiver 2, and the assignment apparatus 3, software modules may be omitted, replaced, and added as appropriate according to an embodiment.

§3 Operation Example

[Transmitter]

Fig. 12 is a flowchart illustrating an example of a processing procedure performed by the transmitter 1 according to the present embodiment. The processing procedure performed by the transmitter 1 described below is an example of a communication method/transmission method (information processing method) on the transmission side. However, the processing procedure performed by the transmitter 1 described below is only an example, and each step may be modified if possible. Further, for the following processing procedure, steps may be omitted, replaced, and added as appropriate according to an embodiment.

In step S101, the controller 11 operates as the generation unit 111, and generates a pulse code train 5 by encoding the transmission information according to the assignment of each pulse code train to a respective codeword. In the present embodiment, the controller 11 references the assignment information 60. Each pulse code train indicated by the assignment information 60 is designed so that any pair of pulse code trains has a maximum of two common pulses under all possible shifts of a discrete number of time slots. In one example of the present embodiment, each pulse code train may be further designed so that the minimum pulse interval is equal to or greater than a predetermined time interval width. The controller 11 encodes one or more codewords constituting the transmission information according to the predetermined assignment indicated by the referenced assignment information 60. Thereby, the controller 11 generates one or more pulse code trains 5.

Note that the transmission information may be acquired in any manner. In one example, the transmitter 1 may include a sensor, and the transmission information may be composed of sensor data obtained by the sensor. Further, the transmission information may include information indicating the type of data to be transmitted. For example, it is assumed that the transmitter 1 is configured to collect both the temperature and humidity with sensors. In addition, it is assumed that the transmitter 1 is configured to transmit one sensor value at a time (i.e., not to be able to transmit the temperature and humidity at the same time). In this case, the transmitter 1 may acquire information indicating the type (temperature or humidity) of a sensor value together with the sensor value as the transmission information. Further, the transmission information may include identification information (ID) of the transmitter 1. When transmitting the transmission information to a specific receiver 2, the transmission information may include identification information (ID) of the receiver 2. When the present embodiment is used in a multi-hop network, the transmission information may include routing information (i.e., information about the route that the message takes from the source to the final destination). When a virtual network is used, the transmission information may include information about the configuration of the virtual network, the position in the configuration, or functions. The transmission information may include a time (e.g., a time stamp). Further, in step S101, the controller 11 may generate a plurality of pulse code trains 5 using the above method illustrated in Figs. 5A-5C. When the pulse code train 5 is generated, the controller 11 proceeds with the processing to the next step S102.

In step S102, the controller 11 operates as the transmission unit 112, and transmits the generated pulse code train 5. In the present embodiment, the controller 11 transmits a pulse signal corresponding to each of the generated one or more pulse code trains 5 via the communication interface 13. Upon completion of the transmission of the pulse code train 5, the controller 11 ends the processing procedure performed by the transmitter 1 according to this operation example.

The controller 11 may repeatedly execute the processes of step S101 to step S102 at any timing. In one example, the controller 11 may execute the processes of step S101 to step S102 at the timing when the transmission information is obtained. Thereby, the transmitter 1 may be configured to continuously transmit a pulse signal.

[Receiver]

Fig. 13 is a flowchart illustrating an example of a processing procedure performed by the receiver 2 according to the present embodiment. The processing procedure performed by the receiver 2 described below is an example of a communication method/reception method (information processing method) on the reception side. However, the processing procedure performed by the receiver 2 described below is only an example, and each step may be modified if possible. Further, for the following processing procedure, steps may be omitted, replaced, and added as appropriate according to an embodiment.

In step S201, the controller 21 operates as the reception unit 211, and receives the pulse code train 5. In the present embodiment, the controller 21 receives a pulse signal corresponding to each of one or more pulse code trains 5 via the communication interface 23. In one example of the present embodiment, the received one or more pulse code trains 5 may be a plurality of pulse code trains 5 generated using the above method illustrated in Figs. 5A-5C. Upon receiving the pulse code train 5, the controller 21 proceeds with the processing to the next step S202.

In step S202, the controller 21 operates as the acquisition unit 212, and acquires the transmission information by decoding the received pulse code train 5 according to the assignment of each pulse code train to a respective codeword. In the present embodiment, the controller 21 references the assignment information 60. The controller 21 decodes the received pulse code train 5 according to the predetermined assignment indicated by the referenced assignment information 60. Thereby, the controller 21 acquires the transmission information. When the pulse code train 5 is generated using the above method illustrated in Figs. 5A-5C, the controller 21 can restore the transmission information using the reverse procedure of the generation processing procedure. The acquired transmission information may be output to a display, any storage area, or the like, for example. Upon completion of the acquisition of the transmission information, the controller 21 ends the processing procedure performed by the receiver 2 according to this operation example.

The controller 21 may repeatedly execute the processes of step S201 to step S202 at any timing. In one example, the controller 21 may execute the processes of step S201 to step S202 each time a pulse signal is received. Thereby, the receiver 2 may be configured to restore the transmission information from continuously received pulse signals.

[Assignment Apparatus]

Fig. 14 is a flowchart illustrating an example of a processing procedure performed by the assignment apparatus 3 according to the present embodiment. The processing procedure performed by the assignment apparatus 3 described below is an example of a method of assigning pulse code trains to codewords (an information processing method). However, the processing procedure performed by the assignment apparatus 3 described below is only an example, and each step may be modified if possible. Further, for the following processing procedure, steps may be omitted, replaced, and added as appropriate according to an embodiment.

(Step S301)

In step S301, the controller 31 operates as the acquisition unit 311, and acquires the number Nc of codewords to be assigned pulse code trains. Identical codewords are counted as one codeword. The number Nc of codewords may be specified in any manner. In one example, the controller 31 may acquire the number Nc of codewords in response to the input from the operator via the input device 34. In another example, the number Nc of codewords may be acquired by counting given codewords. In yet another example, the number Nc of codewords may be acquired from the number of bits encoded using codewords. When the number Nc of codewords is acquired, the controller 31 proceeds with the processing to the next step S302.

(Step S302)

In step S302, the controller 31 operates as the organization unit 312, and organizes candidates for Nc pulse code trains assigned to their respective codewords in blocks. In the present embodiment, candidates for Nc pulse code trains may be obtained in any manner. In an example of the present embodiment, the controller 31 can organize candidates for Nc pulse code trains using the following two types of blocks.

Fig. 15 schematically illustrates an example of a process of organizing candidates for Nc pulse code trains in blocks. As illustrated in Fig. 15, two fixed blocks and n-k free blocks are provided. Each of the provided blocks (fixed blocks/free blocks) includes a two-dimensional array. The first axis of each block corresponds to codewords. In the example of Fig. 15, the first axis direction is the column direction (the up-down direction of the figure). The number of elements in the first axis direction of each block is set to coincide with the acquired number Nc of codewords.

On the other hand, the second axis of each block corresponds to a pulse code train. In the example of Fig. 15, the second axis direction is the row direction (the left-right direction of the figure). Note that the first axis direction and the second axis direction may not be limited to such examples. In another example, the row direction may be set to the first axis direction and the column direction may be set to the second axis direction.

Each element arranged in the second axis direction at each position in the first axis direction of each block as an element string in the second axis direction (row data in the figure) disposed at each position in the first axis direction of each block represents the presence of a pulse using the first value and represents the absence of a pulse using the second value. Thereby, each element arranged in the second axis direction at each position in the first axis direction of each block indicates the presence or absence of a pulse in a candidate for a pulse code train assigned to each codeword. In the example of Fig. 15, as described above, "1" is the first value and "0" is the second value. However, the first value and the second value may not be limited to such examples. The first value and the second value may be set freely.

Each of the two fixed blocks is disposed at a respective one of the head and the tail in the second axis direction. The n-k free blocks are arranged in the second axis direction between the two fixed blocks. A series of element strings in the second axis direction (row data indicated by a dotted line in the figure) extracted from each position in the first axis direction of the two fixed blocks and the n-k free blocks while being arranged in the second axis direction indicates each of the candidates for pulse code trains. The number of elements in the second axis direction after arranging the blocks may correspond to the number of time slots constituting a pulse code train (the time interval width of the pulse code train).

In each of the two fixed blocks, one or more first values are disposed in each element string in the second axis direction disposed at each position in the first axis direction. In the two fixed blocks, a total number of first values disposed in their respective element strings in the second axis direction is k. That is, in the two fixed blocks, the numbers of first values disposed in their respective element strings (row data in the figure) in the second axis direction are the same, and the total number is k. n is equal to or greater than 4 and indicates the number of pulses. The number n of pulses may be given in any manner. In one example, the number n of pulses may be given manually by the operator. In another example, the number n of pulses may be given automatically in any manner. On the other hand, k is equal to or greater than 2 and less than n.

In each element string in the second axis direction in the fixed block disposed at the head in the second axis direction, the first value is disposed at the head in the second axis direction. On the other hand, in each element string in the second axis direction in the fixed block disposed at the tail in the second axis direction, the first value is disposed at the tail in the second axis direction. Note that the number of first values included in each element string in the second axis direction of the fixed block disposed at the head and the number of first values included in each element string in the second axis direction of the fixed block disposed at the tail may or may not coincide with each other.

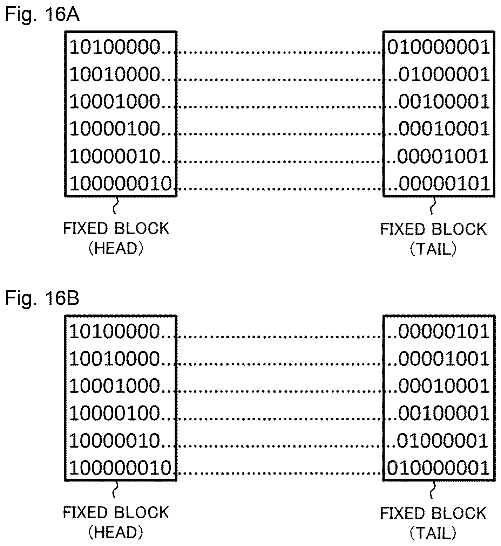

Figs. 16A and 16B illustrate specific examples of disposition of first values and second values in each fixed block. In the ranges other than the above in the fixed blocks (i.e., the ranges other than the head of the head fixed block and the tail of the tail fixed block), either the first value or the second value may be disposed in a predetermined manner. In one example, the disposition of each value may be specified in advance. In another example, the disposition of each value may be specified by the operator. In yet another example, the disposition of each value may be determined by any algorithm, for example, at random.

When k is 3 or more (i.e., the element strings in the second axis direction in the two fixed blocks include a total of three or more first values), the first value is disposed at a position other than the head and tail in the second axis direction. In this case, as illustrated in Figs. 16A and 16B, the first value is disposed in each element string in the second axis direction so that the disposition of the first value does not overlap in the first axis direction (i.e., there are no two or more first values in the first axis direction).

The number of elements in the second axis direction of each free block is equal to or greater than the acquired number Nc of codewords. Organizing the candidates for Nc pulse code trains in blocks includes disposing one first value in each element string in the second axis direction of each free block so that the disposition of the first value does not overlap in the first axis direction (i.e., there are no two or more first values in the first axis direction) and disposing a second value at each of the other positions. The controller 31 may determine the disposition of the first value in each element string in the second axis direction of each free block in any manner, for example, at random. When candidates for Nc pulse code trains are obtained by organizing them in blocks in this way, the controller 31 proceeds with the processing to the next step S303. Note that in one example of the present embodiment, when the minimum pulse interval described above is specified, the first value may be disposed in each block so that the minimum pulse interval is satisfied.

(Step S303)

Returning to Fig. 14, in step S303, the controller 31 operates as the verification unit 313, and verifies the organized candidates for Nc pulse code trains. That is, the controller 31 verifies whether or not the obtained candidates for Nc pulse code trains satisfy the above design of pulse code trains. In the present embodiment, the controller 31 may verify the organized candidates for Nc pulse code trains using either of the above two indices.

In one example, the controller 31 may verify the organized candidates for Nc pulse code trains using characteristic pairs described above. Specifically, each series of element strings in the second axis direction extracted from the two fixed blocks and the n-k free blocks is treated as each of the candidates for pulse code trains. For each of the candidates for pulse code trains, two pulse intervals between three freely-selected pulses may be defined as a characteristic pair. Verifying the candidates for Nc pulse code trains may include determining whether or not there is a combination of coincident characteristic pairs in all characteristic pairs in the candidates for pulse code trains.

In other words, when it is determined that there is no combination of coincident characteristic pairs, the verification is cleared. On the other hand, when it is determined that there is a combination of coincident characteristic pairs, the verification is not cleared, but fails. The controller 31 may terminate the search process in the verification at the point when a combination of coincident characteristic pairs is found. Upon completion of the verification, the controller 31 proceeds with the processing to the next step S304.

(Step S304)

In step S304, the controller 31 determines the branch destination of the processing according to the result of the verification. When it is determined that there is a combination of coincident characteristic pairs (NO in Fig. 14), the controller 31 proceeds with the processing to the next step S305. On the other hand, when it is determined that there is no combination of coincident characteristic pairs (YES in Fig. 14), the controller 31 proceeds with the processing to the next step S307.

(Step S305)

In step S305, the controller 31 operates as the organization unit 312, and determines whether candidates for Nc pulse code trains determined not to include a combination of coincident characteristic pairs have not been obtained although the process of reorganizing the candidates for Nc pulse code trains has been repeated a predetermined number of times or more. In one example, the predetermined number of times may be determined using the number of executions as an index. In another example, the predetermined number of times may be determined using the execution time as an index.

When it is determined that candidates for Nc pulse code trains determined to have cleared the verification have not been obtained although the reorganization process has been repeated the predetermined number of times or more (YES in Fig. 14), the controller 31 proceeds with the processing to the next step S306.

On the other hand, when it is determined that the reorganization process has not been repeated the predetermined number of times or more (NO in Fig. 14), the controller 31 omits the process of step S306 to return the processing to step S302, and executes the processing again from step S302. In this case, in step S302, the controller 31 reorganizes the candidates for Nc pulse code trains by changing the disposition of the first value in at least one of the n-k free blocks. The free block in which the disposition of the first value is to be changed may be determined in any manner. In one example, the disposition of the first value may be changed in the free block involved in the found coincident characteristic pairs, and in the other free blocks, the disposition of the first value may be adopted as it is without changing. In another example, the disposition of the first value may be changed in all free blocks. Note that the disposition of the first value at the time of reorganization may be determined in any manner, for example, at random. In step S303, the controller 31 executes the above verification process on the reorganized candidates for Nc pulse code trains.

(Step S306)

In step S306, the controller 31 operates as the organization unit 312, and increases the number of elements in the second axis direction by one or more in at least one of the n-k free blocks. The free block in which the number of elements in the second axis direction is to be increased by one or more may be determined in any manner, for example, in a predetermined order or at random. The increase in the number of elements in the second axis direction may also be determined in any manner.

In the present embodiment, the smaller the number of elements (width) in the second axis direction of the free blocks, the shorter the time interval width of obtained pulse code trains. That is, pulse code trains with high transmission efficiency are obtained. On the other hand, when the number of elements in the second axis direction of the free blocks is reduced, the number of combinations of pulse code trains that satisfy the above settings decreases, and the search time for Nc pulse code trains that clear the above verification may be increased. Therefore, by increasing the number of elements in the second axis direction by one or more in at least one of the n-k free blocks through the process of step S306, it is made easier to find pulse code trains that satisfy the above settings. Thereby, the search time for Nc pulse code trains that clear the above verification can be reduced. That is, it is possible to control the time until the completion of the assignment of a pulse code train to each codeword (i.e., the generation of pulse code trains) through the process of step S306.

After completion of the process of increasing the number of elements in the second axis direction, the controller 31 returns the processing to step S302 and executes the processing again from step S302. In this case, as described above, in step S302, the controller 31 reorganizes the candidates for Nc pulse code trains by changing the disposition of the first value in at least one of the n-k free blocks. In step S303, the controller 31 executes the above verification process on the reorganized candidates for Nc pulse code trains.

(Step S307)

In step S307, the controller 31 operates as the adoption unit 314, and adopts the organized candidates for Nc pulse code trains as pulse code trains assigned to the Nc codewords. In the present embodiment, the controller 31 may output the adopted Nc pulse code trains as appropriate. In one example, the controller 31 may display the adopted Nc pulse code trains together with the codewords on the display (the output device 35). In another example, the controller 31 may generate information (assignment information 60) indicating the assignment of the adopted Nc pulse code trains to the codewords. The controller 31 may store the generated assignment information 60 in a predetermined storage area. The predetermined storage area may be, for example, the RAM in the controller 31, the storage unit 32, the storage medium 93, an external storage device, or the like. The generated assignment information 60 may be provided to the transmitter 1 and the receiver 2 at any timing in any manner. In one example, the assignment information 60 may be incorporated in advance. In another example, the assignment information 60 may be provided to the transmitter 1 and the receiver 2 via a network, a storage medium, or the like.

When the Nc pulse code trains are obtained, the controller 31 ends the processing procedure performed by the assignment apparatus 3 according to this operation example. The controller 31 may repeatedly execute the processes of step S301 to step S307 at any timing. In one example, the controller 31 may generate Nc pulse code trains assigned to codewords by executing the processes of step S301 to step S307 in response to a request from the operator.

[Features]

As described above, in the present embodiment, the data communication in step S102 and step S201 described above is performed using a pulse code train. Each pulse code train is configured to satisfy the above design. As a result, even if a plurality of devices perform data communication asynchronously, for example, even if a plurality of transmitters 1 transmit data asynchronously to one receiver 2, only a maximum of two pulses coincide among the four or more pulses included in each pulse code train (e.g., in the pulse code train 5 transmitted by each of the two transmitters 1). That is, the remaining two or more pulses do not coincide. Therefore, even if the pulse code trains transmitted from respective transmitters 1 coincide, each of the pulse code trains can be decoded. As a result, a large number of devices can perform communication simultaneously in the same frequency band, and the number of transmissions can be increased. Therefore, according to the present embodiment, it can be expected to improve the data rate in data communication by a large number of devices. Further, according to the processes in step S301 to step S307, pulse code trains usable for such data communication can be obtained appropriately.

§4 Modifications

Although an embodiment of the present invention has been described above in detail, the description up to the above is only an illustration of the present invention in all respects. In the above embodiment, various improvements or changes may be made as appropriate. For example, the following changes are possible. Note that in the following, the same numerals are used for the same components as in the above embodiment, and description of the same respects as in the above embodiment is omitted as appropriate. The following modifications can be combined as appropriate.

<4.1>

In the above embodiment, the transmitter 1 and the receiver 2 are configured to be able to identify the correspondence between codewords and pulse code trains by referencing the assignment information 60. That is, in the above embodiment, the encoder (the generation unit 111) and the decoder (the acquisition unit 212) are composed of software modules. However, the composition of the encoder and the decoder may not be limited to such examples. In another example, at least one of the encoder and the decoder may be composed of a hardware module. For example, at least one of the encoder and the decoder may be composed of a physical circuit such as logic circuits (e.g., AND circuits and OR circuits) and shift registers. When at least one of the encoder and the decoder is composed as a hardware module, the assignment information 60 may be omitted in the corresponding device of the transmitter 1 and the receiver 2.

<4.2>

For each processing procedure of the above embodiment, at least one of omission, replacement, and addition of steps may be performed. For example, in the above processing procedure (in Fig. 14) performed by the assignment apparatus 3, the processes of step S305 and step S306 may be omitted. Further, for example, when variable-length pulse code trains are generated, the tail fixed block may be omitted in step S302. In this case, k may be equal to or greater than 1 and less than n.

Description of the Reference Numerals and Symbols

1... transmitter
11... controller, 12... storage unit, 13... communication interface,
81... transmission program (communication program),
2... receiver,
21... controller, 22... storage unit, 23... communication interface,
82... reception program (communication program),
3... assignment apparatus,
31... controller, 12... storage unit, 13... communication interface,
14... input device, 15... output device, 16... drive
83... assignment program,
5... pulse code train, 60... assignment information

**Claims**

1. A communication program for causing a computer to execute:

   a step of generating a pulse code train by encoding transmission information according to assignment of each of one or more pulse code trains to a respective codeword; and
   a step of transmitting the generated pulse code train, wherein
   each of the one or more pulse code trains includes four or more pulses, and
   each of the one or more pulse code trains is designed so that any pair of the one or more pulse code trains has a maximum of two common pulses under all possible shifts of a discrete number of time slots.

2. The communication program according to claim 1, wherein

each of the one or more pulse code trains includes n pulses,
n is a natural number of four or more,
for two pulse code trains that are paired, a minimum number of pulses dispositions of which do not coincide under all the possible shifts of time slots is defined as a shifting distance, and
designing each of the one or more pulse code trains comprises designing each of the one or more pulse code trains so that a shifting distance between any pair of the one or more pulse code trains is 2n - 4.

3. The communication program according to claim 1, wherein

for each of the one or more pulse code trains, two pulse intervals between three freely-selected pulses are defined as a characteristic pair, and
designing each of the one or more pulse code trains comprises designing each of the one or more pulse code trains so that all characteristic pairs in the one or more pulse code trains are different.

4. The communication program according to claim 1, wherein
each of the one or more pulse code trains is further designed so that a minimum pulse interval in the one or more pulse code trains is equal to or greater than a predetermined time interval width.

5. The communication program according to any one of claims 1 to 4, wherein
the step of generating the pulse code train comprises:

a step of dividing the transmission information into a plurality of groups, wherein each of the groups comprises one or more information bits and one or more check bits and the number of bits belonging to each of the groups is the same;
a step of generating a plurality of frames by repeating generation of one frame by extracting one bit from each of the groups until there is no more bit belonging to each of the groups; and
a step of generating a plurality of the pulse code trains corresponding to the respective frames by handling each of the frames as a codeword.

6. The communication program according to claim 5, wherein
the plurality of frames comprises one or more information frames to which the information bits belong and one or more check frames to which the check bits belong.

7. A communication program for causing a computer to execute:

a step of receiving a pulse code train; and
a step of acquiring transmission information by decoding the received pulse code train according to assignment of each of one or more pulse code trains to a respective codeword; wherein
each of the one or more pulse code trains includes four or more pulses, and
each of the one or more pulse code trains is designed so that any pair of the one or more pulse code trains has a maximum of two common pulses under all possible shifts of a discrete number of time slots.

8. The communication program according to claim 7, wherein

in the step of receiving, the computer receives a plurality of the pulse code trains, and
the received plurality of pulse code trains are generated using:

a step of dividing the transmission information into a plurality of groups, wherein each of the groups comprises one or more information bits and one or more check bits and the number of bits belonging to each of the groups is the same;
a step of generating a plurality of frames by repeating generation of one frame by extracting one bit from each of the groups until there is no more bit belonging to each of the groups; and
a step of generating a plurality of the pulse code trains corresponding to the respective frames by handling each of the frames as a codeword.

9. A method of assigning a pulse code train to a codeword,

wherein a computer executes:

a step of acquiring the number Nc of codewords;
a step of organizing candidates for Nc pulse code trains assigned to respective codewords in blocks,

wherein

two fixed blocks and n-k free blocks are provided,
each of the provided blocks comprises a two-dimensional array,
a first axis of each of the blocks corresponds to a codeword,
the number of elements in a first axis direction of each of the blocks is set to coincide with the acquired number Nc of codewords,
a second axis of each of the blocks corresponds to the pulse code trains,
each element arranged in a second axis direction at each position in the first axis direction of each of the blocks as an element string in the second axis direction disposed at each position in the first axis direction of each of the blocks indicates presence or absence of a pulse in the candidates for pulse code trains assigned to the respective codewords by representing presence of a pulse using a first value and representing absence of a pulse using a second value,
each of the two fixed blocks is disposed at a respective one of a head and a tail in the second axis direction,
the n-k free blocks are arranged in the second axis direction between the two fixed blocks,
a series of element strings in the second axis direction extracted from each position in the first axis direction of the two fixed blocks and the n-k free blocks while being arranged in the second axis direction indicates each of the candidates for pulse code trains,
in each of the two fixed blocks, the first value or a plurality of the first values are disposed in each element string in the second axis direction,
in the two fixed blocks, a total number of the first values disposed in respective element strings in the second axis direction is k,
n is equal to or greater than 4,
k is equal to or greater than 2 and less than n,
in each element string in the second axis direction in the fixed block disposed at the head in the second axis direction, the first value is disposed at the head in the second axis direction,
in each element string in the second axis direction in the fixed block disposed at the tail in the second axis direction, the first value is disposed at the tail in the second axis direction,
the number of elements in the second axis direction of each of the free blocks is equal to or greater than the acquired number Nc of codewords,
organizing the candidates for Nc pulse code trains in blocks comprises disposing the first value in each element string in the second axis direction of each of the free blocks so that disposition of the first value does not overlap in the first axis direction and disposing the second value at each of the other positions; and
a step of verifying the organized candidates for Nc pulse code trains, wherein

each series of element strings in the second axis direction extracted from the two fixed blocks and the n-k free blocks is treated as each of the candidates for pulse code trains,
for each of the candidates for pulse code trains, two pulse intervals between three freely-selected pulses are defined as a characteristic pair,
verifying the candidates for Nc pulse code trains comprises determining whether or not there is a combination of coincident characteristic pairs in all characteristic pairs in the candidates for pulse code trains, wherein

when it is determined that there is a combination of coincident characteristic pairs in the step of verifying, the computer reorganizes the candidates for Nc pulse code trains by changing disposition of the first value in at least one of the n-k free blocks, and executes the step of verifying on the reorganized candidates for Nc pulse code trains, and
when it is determined that there is no combination of coincident characteristic pairs in the step of verifying, the computer adopts the organized candidates for Nc pulse code trains as pulse code trains assigned to the Nc codewords.

10. The method of assigning a pulse code train according to claim 9, wherein

when candidates for Nc pulse code trains determined not to include a combination of coincident characteristic pairs are not obtained although a process of reorganizing the candidates for Nc pulse code trains is repeated a predetermined number of times or more, the computer further executes a step of increasing the number of elements in the second axis direction by one or more in at least one of the n-k free blocks, and

after increasing the number of elements in the second axis direction by one or more in at least one of the n-k free blocks, the computer reorganizes the candidates for Nc pulse code trains by changing disposition of the first value, and executes the step of verifying on the reorganized candidates for Nc pulse code trains.

Fig. 1

FIRST CODEWORD – FIRST PULSE CODE TRAIN
SECOND CODEWORD – SECOND PULSE CODE TRAIN
...

~3

ASSIGNMENT
APPARATUS

2

RECEIVER

1

TRANSMITTER

PULSE CODE
TRAIN

~5

Fig. 2

FIRST PULSE CODE TRAIN: 1001000000000100000000000001001

SECOND PULSE CODE TRAIN: 1000001000000100000001000001

Fig. 3

| PULSE CODE TRAIN | PULSE INTERVAL | CHARACTERISTIC PAIR |
|---|---|---|
| 1: 101000000000100000000001000001 | 1/ 8/ 9/ 5 | (1,8),(8,9),(9,5),(10,9),(1,18),(18,5),(8,15),(1,24),(10,15),(20,5) |
| 2: 100100001000000100000000001 | 2/ 4/ 7/ 10 | (2,4),(4,7),(7,10),(7,7),(2,12),(12,10),(4,18),(2,23),(7,18),(15,10) |
| 3: 1000101000000000000100000001 | 3/ 1/ 12/ 7 | (3,1),(1,12),(12,7),(3,14),(14,7),(5,12),(1,20),(3,22),(5,20),(18,7) |
| 4: 100001000000001000100000000001 | 4/ 8/ 3/ 8 | (4,8),(8,3),(3,8),(13,3),(4,12),(12,8),(8,12),(4,21),(13,12),(17,8) |
| 5: 1000000101000001000000000001 | 6/ 1/ 5/ 11 | (6,1),(1,5),(5,11),(8,5),(6,7),(7,11),(1,17),(6,19),(8,17),(14,11) |
| 6: 1000000000100100000000000101 | 9/ 2/ 11/ 1 | (9,2),(2,11),(11,1),(12,11),(9,14),(14,1),(2,13),(9,16),(12,13),(24,1) |
| 7: 10000000000100000000101001 | 11/ 9/ 1/ 2 | (11,9),(9,1),(1,2),(21,1),(11,11),(11,2),(9,4),(11,14),(21,4),(23,2) |
| 8: 10000000000000010010010001 | 16/ 2/ 2/ 3 | (16,2),(2,2),(2,3),(19,2),(16,5),(5,3),(2,6),(16,9),(19,6),(22,3) |

Fig. 4

FIRST PULSE CODE TRAIN →

MPI

SECOND PULSE CODE TRAIN →

THIRD PULSE CODE TRAIN →

MPI          MPI

Fig. 5A

Fig. 5B

## INFORMATION BITS          CHECK BIT

| | d1 | d2 | d3 | d4 | p1 |
|---|---|---|---|---|---|
| FRAME | 0 | 0 | 0 | 1 | 1 |
| | 1 | 1 | 0 | 0 | 0 |
| | 0 | 1 | 0 | 1 | 0 |
| | 2 | 3 | 0 | 5 | 4 |

CONVERTED INTO PULSE CODE TRAINS

Fig. 5C

Fig. 6

Fig. 7

Fig. 8

3

**ASSIGNMENT APPARATUS**

32 — STORAGE UNIT

83 — ASSIGNMENT PROGRAM

60 — ASSIGNMENT INFORMATION

CONTROLLER

CPU

RAM

ROM

31

34 — INPUT DEVICE

35 — OUTPUT DEVICE

COMMUNICATION I/F — 33

DRIVE

36

93

STORAGE MEDIUM

Fig. 9

1

**TRANSMITTER**

GENERATION UNIT — 111

TRANSMISSION UNIT — 112

Fig. 10

2

RECEIVER

RECEPTION
UNIT ~211

ACQUISITION
UNIT ~212

Fig. 11

3

ASSIGNMENT
APPARATUS

ACQUISITION
UNIT ~311

ORGANIZATION
UNIT ~312

VERIFICATION
UNIT ~313

ADOPTION
UNIT ~314

Fig. 12

```
                    ┌──────────┐
                    │  START   │
                    └────┬─────┘
                         │
                         ▼
          ┌─────────────────────────────────────────┐
          │      GENERATE PULSE CODE TRAIN           │
  S101 ~  │  BY ENCODING TRANSMISSION INFORMATION    │
          │      ACCORDING TO ASSIGNMENT             │
          └─────────────────────┬───────────────────┘
                                │
                                ▼
          ┌─────────────────────────────────────────┐
  S102 ~  │   TRANSMIT GENERATED PULSE CODE TRAIN    │
          └─────────────────────┬───────────────────┘
                                │
                                ▼
                          ┌──────────┐
                          │   END    │
                          └──────────┘
```

Fig. 13

```
                    ┌──────────┐
                    │  START   │
                    └────┬─────┘
                         │
                         ▼
          ┌─────────────────────────────────────────┐
  S201 ~  │         RECEIVE PULSE CODE TRAIN         │
          └─────────────────────┬───────────────────┘
                                │
                                ▼
          ┌─────────────────────────────────────────┐
          │    ACQUIRE TRANSMISSION INFORMATION      │
  S202 ~  │     BY DECODING PULSE CODE TRAIN         │
          │      ACCORDING TO ASSIGNMENT             │
          └─────────────────────┬───────────────────┘
                                │
                                ▼
                          ┌──────────┐
                          │   END    │
                          └──────────┘
```

## Fig. 14

START

S301 — ACQUIRE NUMBER OF CODEWORDS

S302 — ORGANIZE CANDIDATES FOR PULSE CODE TRAINS ASSIGNED TO RESPECTIVE CODEWORDS IN BLOCKS

S303 — VERIFY ORGANIZED CANDIDATES FOR PULSE CODE TRAINS

S304 — VERIFICATION CLEARED? — NO → S305 — PREDETERMINED NUMBER OF TIMES OR MORE? — NO

YES ↓ (from S305)

S306 — INCREASE NUMBER OF ELEMENTS IN SECOND AXIS DIRECTION IN FREE BLOCK

S304 YES ↓

S307 — ADOPT ORGANIZED CANDIDATES FOR PULSE CODE TRAINS

END

## Fig. 15

SECOND AXIS DIRECTION

INDICATE CANDIDATE FOR PULSE CODE TRAIN

$N_c$

| 10··· | | | | ···01 |
| 10··· | | | | ···01 |
| FIXED BLOCK (HEAD) | FREE BLOCK | ● ● ● ● ● | FREE BLOCK | FIXED BLOCK (TAIL) |

FIRST AXIS DIRECTION

n−k BLOCKS

Fig. 16A

| | |
|---|---|
| 10100000.. | 010000001 |
| 10010000.. | ..01000001 |
| 10001000.. | ..00100001 |
| 10000100.. | ..00010001 |
| 10000010.. | ..00001001 |
| 100000010 | ..00000101 |

FIXED BLOCK
(HEAD)

FIXED BLOCK
(TAIL)

Fig. 16B

| | |
|---|---|
| 10100000.. | ..00000101 |
| 10010000.. | ..00001001 |
| 10001000.. | ..00010001 |
| 10000100.. | ..00100001 |
| 10000010.. | ..01000001 |
| 100000010 | 010000001 |

FIXED BLOCK
(HEAD)

FIXED BLOCK
(TAIL)

## INTERNATIONAL SEARCH REPORT

| International application No. |
| --- |
| **PCT/JP2024/001267** |

---

**A. CLASSIFICATION OF SUBJECT MATTER**

*H04L 25/49*(2006.01)i; *H03M 7/20*(2006.01)i; *H04J 13/10*(2011.01)i
FI: H04L25/49 J; H04J13/10; H03M7/20

According to International Patent Classification (IPC) or to both national classification and IPC

---

**B. FIELDS SEARCHED**

Minimum documentation searched (classification system followed by classification symbols)

H04L25/49; H03M7/20; H04J13/10

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

IEEE Xplore

---

**C. DOCUMENTS CONSIDERED TO BE RELEVANT**

| Category* | Citation of document, with indication, where appropriate, of the relevant passages | Relevant to claim No. |
| --- | --- | --- |
| A | PEPER, Ferdinand et al., High-Density Resource-Restricted Pulse-Based IoT Networks [online], IEEE Transactions on Green Communications and Networking, 17 June 2021, volume: 5, issue: 4, pages 1856-1868, [retrieved on 28 March 2024]/Retrieved from the Internet: <URL:https://ieeexplore.ieee.org/stamp/stamp.jsp?tp=&arnumber=9459186> | 1-10 |
| A | WO 2020/017484 A1 (NATIONAL INSTITUTE OF INFORMATION AND COMMUNICATIONS TECHNOLOGY) 23 January 2020 (2020-01-23) | 1-10 |
| A | US 2008/0012688 A1 (HA et al.) 17 January 2008 (2008-01-17) | 1-10 |
| A | 本多顕太郎, 500台の送信機を用いた高密度通信方式APCMAの実証, 電子情報通信学会技術研究報告, 31 October 2022, vol. 122, no. 243, pages 105-108, (HONDA, Kentaro, Demonstration of a high-density communication scheme APCMA using 500 transmitters, IEICE Technical Report) | 1-10 |

---

☑ Further documents are listed in the continuation of Box C.    ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **28 March 2024** | **09 April 2024** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**INTERNATIONAL SEARCH REPORT**

| International application No. |
| --- |
| **PCT/JP2024/001267** |

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | 中村敦. 高密度IoT向けCSS-APCMA方式のGNU Radio/USRPを用いた性能評価. 電子情報通信学会技術研究報告, 02 June 2022, vol. 122, no. 66, pages 106-110, (NAKAMURA, Atsushi. Performance evaluation of CSS-APCMA applied to Massive IoT using GNU Radio/ USRP. IEICE Technical Report) | 1-10 |

Form PCT/ISA/210 (second sheet) (July 2022)

## INTERNATIONAL SEARCH REPORT
### Information on patent family members

International application No.

**PCT/JP2024/001267**

| Patent document cited in search report | | | Publication date (day/month/year) | Patent family member(s) | | | Publication date (day/month/year) |
|---|---|---|---|---|---|---|---|
| WO | 2020/017484 | A1 | 23 January 2020 | JP | 2020-14093 | A | |
| | | | | US | 2021/0328623 | A1 | |
| | | | | EP | 3826249 | A1 | |
| US | 2008/0012688 | A1 | 17 January 2008 | WO | 2008/036451 | A2 | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- *What is LPWA (LPWAN)? Low Power Wide Area*, 23 January 2023, https://soracom.jp/lpwa/>